# EUROPÄISCHE PATENTSCHRIFT

(11) **EP 0 293 637 B1**
(45) Veröffentlichungstag und Bekanntmachung des Hinweises auf die Patenterteilung: **26.01.1994**
(21) Anmeldenummer: 88107396.9
(22) Anmeldetag: 07.05.1988
(51) Int. Cl.: H05K 7/18

(54) **Einschubrahmengestell mit wegklappbarer Abdeckplatte**
Cabinet frame for drawers with foldable covering plate
Armoire à cadre pour tiroir munie d'une plaque de recouvrement rabattable

(30) Priorität: 20.05.1987 DE 3716820
(43) Veröffentlichungstag der Anmeldung: 07.12.1988
(73) Patentinhaber: Alcatel SEL Aktiengesellschaft, D-70435 Stuttgart (DE)
(72) Erfinder: Sczepur, Franz, D-8520 Erlangen (DE); Pfeiffer, Katharina, D-8501 Schwaig 2 (DE)
(74) Vertreter: Hösch, Günther, Dipl.-Ing.

(56) Entgegenhaltungen:
- DE-A- 2 257 142
- DE-A- 2 810 572

## Beschreibung

Die vorliegende Erfindung bezieht sich auf ein Einschubrahmengestell gemäß dem Oberbegriff des Anspruchs 1.

Derartige wegklappbare Abdeckplatten an Einschubrahmengestellen sind in der Regel um ihre Klappachse um ca. 180° klappbar. Es kann daher vorkommen, daß bei nach unten klappbarer Abdeckplatte diese ungebremst nach unten fällt. Hierbei kann sie z.B. auf Einstellknöpfe oder Drucktastenknöpfe oder Leuchtenabdeckungen auf einer darunter befindlichen Frontplatte etc. fallen und gegebenenfalls eine Zerstörung dieser Bauteile und/oder eine Fehlschaltung verursachen.

Eine Ausführung mit geringerem Öffnungswinkel als 180° ist beispielsweise bekannt aus der DE-A-2 257 142. Die Abdeckplatte ist dort als seitlich aufschwenkbare Türe ausgebildet, die mit zwei Scharnieren über je einen Distanzbolzen am Rahmengestell befestigt ist. Der Öffnungswinkel der Tür ist allein durch die Ausbildung der Scharniere vorgegeben. Dieser hängt bei Scharnieren von der Art der Freischnitte der Scharnierbänder im Bereich der Scharniergelenke und die Art der Gelenkausbildung ab. Die aus der genannten Druckschrift bekannten Scharniere sind leicht nach außen gekröpft.

Mit der vorliegenden Erfindung soll daher die Aufgabe gelöst werden, eine Abdeckplatte so anzubringen, daß die genannten Mißstände vermieden werden.

Gelöst wird diese Aufgabe durch die im Kennzeichen des Anspruchs 1 angegebenen Merkmale. Dadurch ist in einfacher Weise der Öffnungswinkel der Abdeckplatte auch noch nachträglich begrenzbar. Die Begrenzung kann bei nach unten klappbarer Abdeckplatte so vorgenommen werden, daß die Abdeckplatte in Öffnungsstellung waagrecht verläuft. Hierdurch kann sie zusätzlich als Ablage von Kleinteilen und/oder zur Auflage oder Stütze der Hand bei einer Montage oder Demontage etc. verwendet werden.

Weitere vorteilhafte Einzelheiten der Erfindung sind in den Unteransprüchen enthalten und nachfolgend anhand der in der Zeichnung veranschaulichten Ausführungsbeispiele beschrieben.

Es zeigen:

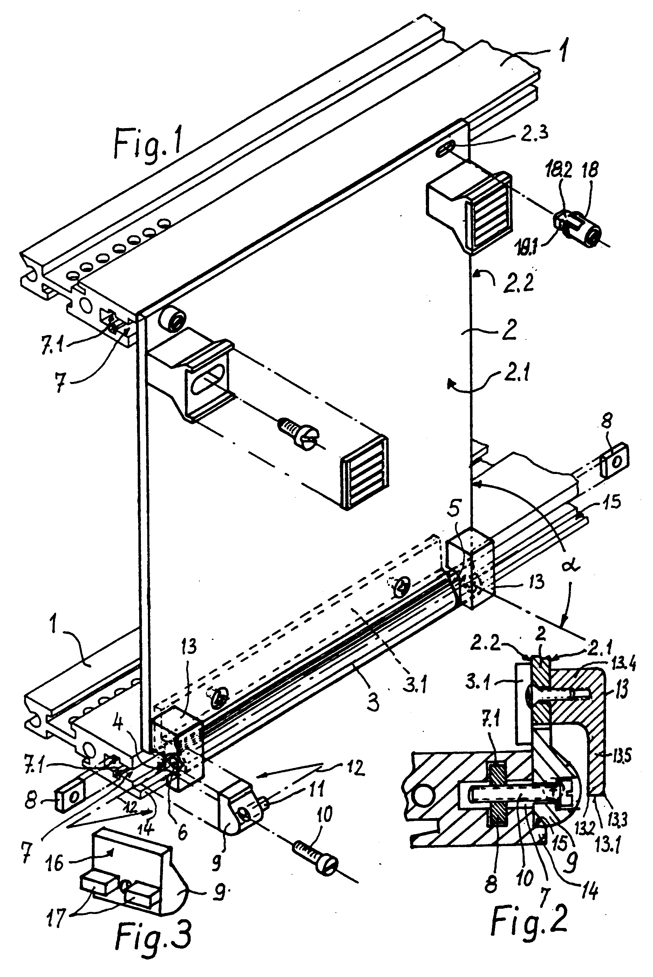

- Fig. 1: einen Einschubrahmengestell-Ausschnitt mit Abdeckplatte in perspektivischer Ansicht,
- Fig. 2: eine Seitenanschicht des Anlenkbereiches der Abdeckplatte im Schnitt und
- Fig. 3: eine vorteilhafte Ausbildung eines Lagerbockes in perspektivischer Ansicht.

Mit 1 sind waagrecht verlaufende Profilschienen eines Einschubrahmengestells für beispielsweise gedruckte Schaltungsplatinen, Meßgeräte, Lüfter etc., wie sie beispielsweise für Schaltschränke oder Laborgeräte usw. verwendet werden, bezeichnet. Mit den Profilschienen 1 sind in an sich bekannter Weise weitere nicht gezeichnete senkrechte und nach hinten ragende Profilschienen gleichen oder anderen Querschnitts zu einem Rahmengestell für ein Gehäuse verbunden. Die offenen Seiten können mit Abdeckplatten geschlossen werden. An wenigstens einer Seite, in der Regel an der Frontseite und/oder der Rückseite, ist eine Abdeckplatte 2 meist nach unten wegklappbar gelagert. Hierzu ist letztere mit einem Abschlußrand 3 versehen, an dessen beiden Endseiten 4 und 5 je eine Lagerstelle 6 in Form einer Bohrung oder auch eines Lagerzapfens vorgesehen ist. Der Abschlußrand 3 kann an der Abdeckplatte 2 angeformt sein. Vorteilhaft besteht er jedoch aus einer Leiste, die mittels eines Flansches 3.1 an der Abdeckplatte 2 befestigt, z.B. angeschraubt oder angenietet wird.

Die Profilschienen 1 besitzen einen nach vorn bzw. zur Abdeckplatte 2 hin offenen Längsschlitz 7. Dieser ist im Querschnitt etwa kreuzförmig ausgebildet. In dem senkrechten Kreuzbalken 7.1 ist zu beiden Seiten der Abdeckplatte 2 je ein Gewindestück 8 in Form einer Mutter, oder der Kopf einer Schraube, von der Seite her eingeschoben. Mit diesen Gewindestücken 8 ist je ein auf einen Abschnitt des Längsschlitzes 7 von vorn aufsetzbarer Lagerbock 9 mittels einer Schraube 10 bzw. einer Mutter verschraubt.

Die Lagerböcke 9 besitzen einen seitlich abstehenden Lagerzapfen 11, der in die als Bohrung ausgebildete Lagerstelle 6 des Abschlußrandes 3 eingreift. Dadurch ist die Abdeckplatte 2 nach unten wegklappbar um die Schwenkachse 12 gelagert. In dieser Montageart kann die Abdeckplatte 2 um einen Öffnungswinkel α von etwa 180° nach unten geklappt werden.

Zur Begrenzung des Öffnungswinkels α ist erfindungsgemäß an der Außenseite 2.1 der Abdeckplatte 2 wenigstens ein Anschlagblock 13 angebracht, z.B. angeschraubt oder angenietet. Dieser ist so angeordnet, daß seine eine Endfläche 13.1 oder beispielsweise bei gerundeter oder schräger Endfläche wenigstens eine Endkante 13.2 und/oder 13.3 in weggeklapptem Zustand bei einem bestimmten Öffnungswinkel α, insbesondere von 90°, an einem Rahmenteil 14 anschlägt. Im Ausführungsbeispiel ist dieses Rahmenteil 14 als an der Profilschiene 1 angeformte Anschlagleiste ausgebildet, an deren Vorderseite die Endfläche 13.1 oder/und eine Endkante 13.2 bzw./und 13.3 anschlagen kann. Der durch die Anschlagleiste gebildete Falz 15 dient zur Lagefixierung der Lagerböcke 9, so daß diese zwar längsverschiebbar aber unverdrehbar sind. Anstelle des Falzes 15 oder zusätzlich dazu kann an der Befestigungsfläche 16 des Lagerbockes 9 wenigstens ein quer verlaufender Führungsansatz 17 beispielsweise in Form eines oder mehrerer Stege angebracht sein, der in den Längsschlitz 7 hineinragt und bei der Montage eine verschiebbare Lagesicherung gewährleistet.

An sich ist ein Anschlagblock 13 für die vorgesehene Wirkung ausreichend. Zweckmäßig sind jedoch zwei Anschlagblöcke 13 vorgesehen, die die Lagerstelle 6 und zweckmäßig den gesamten Lagerbock 9 und den angrenzenden Trennspalt zum Abschlußrand 3 hin abdeckt oder übergreift. Es kann auch wenigstens ein Anschlagblock 13 in der Mitte oder sonst an einer Stelle zwischen den Lagerböcken 9 vorgesehen sein. Gegebenenfalls können zusätzlich zu den seitlichen Lagerböcken 9 auch in der Mitte einer oder mehrere angebracht werden.

Zweckmäßig ist der Anschlagblock 13 als Winkel ausgebildet, dessen einer Winkelschenkel 13.4 derart an der Außenseite 2.1 der Abdeckplatte 2 befestigt ist daß der andere freistehende Winkelschenkel 13.5 im Abstand von der Abdeckplatte 2 und im wesentlichen in Richtung der Ebene der Abdeckplatte 2 verläuft und sich zur Schwenkachse 12 hin erstreckt. Die Länge des freien Winkelschenkels 13.5 ist so gewählt, daß seine Endfläche 13.1 oder eine Endkante 13.2 und/oder 13.3 nach dem Öffnen um den gewünschten Öffnungswinkel α am Rahmenteil 14 anschlägt.

Zweckmäßig ist der Lagerblock 13 von der Innenseite 2.2 der Abdeckplatte 2 her befestigt, insbesondere verschraubt oder vernietet.

Die Abdeckplatte 2 ist im geschlossenen Zustand durch wenigstens ein an sich bekanntes Rast-Drehglied 18 verriegelbar, indem zumindest eine hintergreifende Kante 18.1 eines gegen Federdruck verschiebbaren Dreh-Schiebegliedes 18.2 durch eine Öffnung 2.3 der Abdeckplatte 2 in den Längsschlitz 7 der oberen Profilschiene 1 einsteckbar ist. Die überstehenden Kanten 18.1 des Rast-Drehgliedes 18 greifen in den senkrechten Kreuzbalken 7.1 des Längsschlitzes 7 ein und können durch Verdrehen des Rast-Drehgliedes 18 die Abdeckplatte in ihrer geschlossenen Stellung halten.

## Patentansprüche

1. Einschubrahmengestell aus Profilschienen, für elektrische Geräte oder Schaltschränke, mit wenigstens einer wegklappbar angebrachten Abdeckplatte,
**dadurch gekennzeichnet,** daß an der Außenseite (2.1) der Abdeckplatte (2) wenigstens ein separater, mit einem Winkelschenkel (13.5) versehener Anschlagblock (13) derart angebracht ist, daß der Winkelschenkel (13.5) im Abstand von der Abdeckplatte (2) verläuft und sich zur Schwenkachse (12) der Abdeckplatte (2) hin erstreckt und dessen Endfläche (13.1) oder eine Endkante (13.2 und/oder 13.3) in weggeklapptem Zustand an einem Rahmenteil (14) anschlägt und so den Öffnungswinkel (α) der Abdeckplatte (2) begrenzt.

2. Einschubrahmengestell nach Anspruch 1, dadurch gekennzeichnet, daß zu beiden Endseiten (4, 5) eines Abschlußrandes (3) der Abdeckplatte (2) je eine Lagerstelle (6) vorgesehen ist und jeder Lagerstelle (6) ein an einer Profilschiene (1) befestigter Lagerbock (9) zugeordnet ist.

3. Einschubrahmengestell nach Anspruch 1 oder 2, dadurch gekennzeichnet, daß die Abdeckplatte (2) an einer Profilschiene (1) schwenkbar angeordnet ist, indem die Profilschiene (1) einen nach vorn bzw. zur Abdeckplatte (2) hin offenen Längsschlitz (7) mit im Querschnitt etwa kreuzförmiger Gestalt aufweist, in dessen senkrechten Kreuzbalken (7.1) ein Gewindestück (8) von der Seite her verschiebbar eingesetzt ist und der Lagerbock (9) den Längsschlitz (7) abdeckt und mit dem Gewindestück (8) verschraubt ist.

4. Einschubrahmengestell nach einem der Ansprüche 1 bis 3, dadurch gekennzeichnet, daß der Anschlagblock (13) den Lagerbock (9) übergreift.

5. Einschubrahmengestell nach einem der Ansprüche 1 bis 4, dadurch gekennzeichnet, daß die Profilschiene (1) ein als Anschlagleiste für den Lagerbock (9) ausgebildetes Rahmenteil (14) aufweist, das lediglich eine Verschiebung des Lagerbockes (9) in Richtung der Schwenkachse (12) der Abdeckplatte (2) gestattet.

6. Einschubrahmengestell nach einem der Ansprüche 1 bis 5, dadurch gekennzeichnet, daß der Lagerbock (9) wenigstens einen in den Längsschlitz (7) ragenden Führungsansatz (17) aufweist, der im Längsschlitz (7) gleitend geführt ist.

7. Einschubrahmengestell nach einem der Ansprüche 1 bis 6, dadurch gekennzeichnet, daß der Anschlagblock (13) als Winkel ausgebildet ist, dessen einer Winkelschenkel (13.4) derart an der Außenseite (2.1) der Abdeckplatte (2) befestigt ist, daß der andere freie Winkelschenkel (13.5) in der Ebene der Abdeckplatte (2) verläuft und die Länge des freien Winkelschenkels (13.5) so bemessen ist, daß dessen Endfläche (13.1) oder zumindest eine Endkante (13.2 und/oder 13.3) in aufgeklapptem Zustand der Abdeckplatte (2) am Rahmenteil (14) anschlägt und den Öffnungswinkel (α) begrenzt.

8. Einschubrahmengestell nach einem der Ansprüche 1 bis 7, dadurch gekennzeichnet, daß der Anschlagblock (13) von der Innenseite (2.2) der Abdeckplatte (2) her angeschraubt ist.

## Claims

1. Frame for slide-in units for electrical appliances or switch cabinets, consisting of profiled rails and with at least one swing-out cover plate, characterised in that at least one separate stop block (13), which is provided with an angle leg (13.5), is attached to the outside (2.1) of the cover plate (2) such that the angle leg (13.5) extends at a distance from the cover plate (2) and towards the pivot axis (12) of the cover plate (2) and its end face (13.1) or an end edge (13.2 and/or 13.3) strikes against a frame part (14) when the plate is swung out and thus limits the opening angle (α) of the cover plate (2).

2. Frame for slide-in units according to claim 1, characterised in that a respective bearing point (6) is provided at the two end sides (4, 5) of a closing edge (3) of the cover plate (2), and a bearing block (9), which is secured to a profiled rail (1), is associated with each bearing point (6).

3. Frame for slide-in units according to claim 1 or 2, characterised in that the cover plate (2) is pivotably arranged at a profiled rail (1) by providing the profiled rail (1) with a longitudinal slot (7) which is open towards the front or the cover plate (2) and has an approximately cruciform shape, in the vertical crosspiece (7.1) of which a threaded part (8) is inserted from the side so as to be displaceable, and the bearing block (9) covers the longitudinal slot (7) and is screwed to the threaded part (8).

4. Frame for slide-in units according to one of claims 1 to 3, characterised in that the stop block (13) engages over the bearing block (9).

5. Frame for slide-in units according to one of claims 1 to 4, characterised in that the profiled rail (1) comprises a frame part (14) which is formed as a stop strip for the bearing block (9) and which only allows the bearing block (9) to be displaced in the direction of the pivot axis (12) of the cover plate (2).

6. Frame for slide-in units according to one of claims 1 to 5, characterised in that the bearing block (9) comprises at least one guide projection (17) which projects into the longitudinal slot (7), in which it slides.

7. Frame for slide-in units according to one of claims 1 to 6, characterised in that the stop block (13) is formed as an angle, one angle leg (13.4) of which is secured to the outside (2.1) of the cover plate (2) such that the other, free angle leg (13.5) extends in the plane of the cover plate (2), and the length of the free angle leg (13.5) is such that its end face (13.1) or at least one end edge (13.2 and/or 13.3) strikes against the frame part (14) when the cover plate (2) is swung open and limits the opening angle (α).

8. Frame for slide-in units according to one of claims 1 to 7, characterised in that the stop block (13) is screwed on from the inside (2.2) of the cover plate (2).

## Revendications

1. Ossature de cadre pour tiroir, en rails profilés, pour apparails électriques ou armoires de commande électriques, comportant au moins une plaque de recouvrement rapportée rabattable,
ossature caractérisée par le fait que sur la face extérieure (2.1) de la plaque de recouvrement (2) est rapporté au moins un bloc de butée (13) distinct, présentant une branche en équerre (13.5), de façon telle que la branche en équerre (13.5) se trouve à une certaine distance de la plaque de recouvrement (2) et s'étende jusqu'à l'axe de pivotement (12) de la plaque de recouvrement (2) et que sa surface d'extrémité (13.1), ou bien ou une arête d'extrémité (13.2 et/ou 13.3), bute, à l'état rabattu, contre une partie (14) du cadre et limite ainsi l'angle d'ouverture (α) de la plaque de recouvrement (2).

2. Ossature de cadre pour tiroir selon la revendication 1, caractérisée par le fait qu'au deux faces d'extrémité (4,5) d'une bordure (3) de la plaque de recouvrement (2) est chaque fois prévue une portée (6) et qu'à cette portée (6) correspond un palier (9) fixé au rail profilé (1).

3. Ossature de cadre pour tiroir selon la revendication 1 ou 2, caractérisée par le fait que la plaque de recouvrement (2) est disposée, avec liberté de pivotement, sur un rail profilé (1), en ce sens que le rail profilé (1) présente une fente longitudinale (7), ouverte vers l'avant ou vers la plaque de recouvrement (2), dont la section a un peu près la forme d'une croix dans la branche verticale (7.1) de laquelle est insérée, de par le côté, avec liberté de coulissement, une pièce filetée (8), et par le fait que le palier (9) recouvre la fente longitudinale (7) et se visse dans la pièce filetée (8).

4. Ossature de cadre pour tiroir selon l'une des revendications 1 à 3, caractérisée par le fait que le bloc de butée (13) surplombe le palier (9).

5. Ossature de cadre pour tiroir selon l'une des revendications 1 à 4, caractérisée par le fait que le rail profilé (1) présente une partie de cadre (14) qui est conçue en tant que profilé de butée pour le palier (9), autorisant uniquement un coulissement du palier (9) selon la direction de l'axe de pivotement (12) de la plaque de recouvrement (2).

6. Ossature de cadre pour tiroir selon une des revendications 1 à 5, caractérisée par le fait que le palier (9) présente au moins un appendice de guidage (17) qui pénètre dans la fente longitudinale (7) et qui est guidée, en glissant, dans cette fente longitudinale (7).

7. Ossature de cadre pour tiroir selon l'une des revendications 1 à 6, caractérisée par le fait que le bloc de butée (13) est conçue sous forme d'une équerre dont une première branche (13.4) de l'équerre est fixée à la face extérieure (2.1) de la plaque de recouvrement (2) de façon telle que l'autre branche (13.5), libre, de l'équerre se trouve dans le plan de la plaque de recouvrement (2) et par le fait que la longueur de la branche libre (13.5) de l'équerre est dimensionnée de façon que sa surface d'extrémité (13.1), ou tout au moins une arête d'extrémité (13.2) et/ou (13.3), bute, à l'état rabattu, ouvert, de la plaque de recouvrement (2), contre la partie (14) du cadre et limite l'angle d'ouverture (α).

8. Ossature de cadre selon l'une des revendications 1 à 7, caractérisée par le fait que le bloc de butée (13) se visse depuis la face intérieure (2.2) de la plaque de recouvrement (2).
